(19) Europäisches Patentamt
European Patent Office
Office européen des brevets

(11) Veröffentlichungsnummer : **0 347 660 B1**

(12) # EUROPÄISCHE PATENTSCHRIFT

(45) Veröffentlichungstag der Patentschrift :
**22.03.95 Patentblatt 95/12**

(51) Int. Cl.$^6$ : **G03F 7/023,** G03F 7/004

(21) Anmeldenummer : **89110425.9**

(22) Anmeldetag : **09.06.89**

(54) **Strahlungsempfindliches Gemisch und hieraus hergestelltes strahlungsempfindliches Aufzeichnungsmaterial.**

(30) Priorität : **18.06.88 DE 3820699**

(43) Veröffentlichungstag der Anmeldung :
**27.12.89 Patentblatt 89/52**

(45) Bekanntmachung des Hinweises auf die Patenterteilung :
**22.03.95 Patentblatt 95/12**

(84) Benannte Vertragsstaaten :
**CH DE FR GB IT LI NL**

(56) Entgegenhaltungen :
**EP-A- 0 212 440**
**EP-A- 0 287 212**
**DE-A- 2 352 139**
**JP-B- 5 228 401**

(73) Patentinhaber : **HOECHST AKTIENGESELLSCHAFT**
**D-65926 Frankfurt (DE)**

(72) Erfinder : **Elsässer, Andreas, Dr. Dipl.-Chem.**
**Hertastrasse 1 b**
**D-6270 Idstein (DE)**
Erfinder : **Frass, Hans Werner, Dr. Dipl.-Chem.**
**Erbsenacker 37**
**D-6200 Wiesbaden (DE)**
Erfinder : **Mohr, Dieter, Dr. Dipl.-Chem.**
**Eaubonner Strasse 8**
**D-6501 Budenheim (DE)**

**EP 0 347 660 B1**

Anmerkung : Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

## Beschreibung

Die Erfindung betrifft ein positiv arbeitendes strahlungs- bzw. lichtempfindliches Gemisch, das als wesentliche Bestandteile

a) ein in Wasser unlösliches in wäßrig-alkalischen Lösungen lösliches polymeres Bindemittel und

b) ein 1,2-Chinondiazid oder eine Kombination aus

1) einer unter Einwirkung von aktinischer Strahlung starke Säure bildenden Verbindung und

2) einer Verbindung mit mindestens einer spaltbaren C-O-C-Bindung

enthält. Die Erfindung betrifft auch ein strahlungsempfindliches Aufzeichnungsmaterial aus einem Schichtträger und dem darauf aufgebrachten strahlungsempfindlichen Gemisch.

Positiv arbeitende lichtempfindliche Gemische, d.h. Gemische aus den genannten Bestandteilen, deren Kopierschicht an den belichteten Stellen löslich wird, sind bekannt und für vielfältige Anwendungsmöglichkeiten, wie zur Herstellung von Photoresists oder Flachdruckplatten beschrieben.

Ein wesentlicher Teil der Eigenschaften dieser Kopierschichten wird vom mengenmäßigen Hauptbestandteil des lichtempfindlichen Gemisches, dem Bindemittel, bestimmt.

Als Bindemittel für Positiv-Kopierschichten werden praktisch ausschließlich Phenol- oder Kresol-Formaldehyd-Kondensationsprodukte vom Novolaktyp eingesetzt. Für einige Anwendungen von Positiv-Kopierschichten sind jedoch die daraus resultierenden Eigenschaften noch nicht optimal. Das betrifft insbesondere die Wärmestandfestigkeit im Falle von Photoresistanwendungen und die Höhe der Druckauflagen bei der Verwendung als Flachdruckplatten.

Es hat sich gezeigt, daß durch Substitution der Novolake durch Bindemittel mit höherer Glasübergangstemperatur ein generell besseres Eigenschaftsprofil resultiert. So sind eine ganze Reihe von alkalilöslichen Bindemitteln für Positiv-Kopierschichten beschrieben, wie etwa Phenolharze auf Naphtholbasis (US-PS 4 551 409), Homo- und Copolymerisate von Vinylphenolen (DE-A- 2 322 230 entsprechend US-PS 3 869 292 und DE-A-3 406 927 entsprechend US-PS 4 678 737), Polymerisate der Ester von Acrylsäuren mit Phenolen (JP-OS 76/36 129, EP-A 0 212 440 und EP-A-0 212 439) oder Copolymerisate von Hydroxyphenylmaleinsäureimiden (EP-A-0 187 517).

Ein positiv-arbeitendes, lichtempfindliches Gemisch mit einem o-Naphthochinondiazid-sulfonsäure-Derivat als lichtempfindlicher Komponente und einem polymeren Bindemittel, das Acrylamid-Einheiten enthält, ist in der JP-B 52/28 401 offenbart. Das Amid-Stickstoffatom der Acrylamid-Einheiten ist dabei entweder direkt oder über eine zweiwertige organische Gruppe mit einem Hydroxyphenyl- oder Hydroxynaphthylrest verknüpft. Konkret offenbart als zweiwertige organische Gruppen ist die Propan-1,3-diyl-Gruppe. Die in mit dem Gemisch hergestellten positiven Reliefbilder sind unter den üblichen Einbrennbedingungen nicht thermisch vernetzbar.

Bindemittel der genannten Art konnten aber bislang keine praktische Anwendung finden. Ein Grund hierfür ist, daß diese Polymeren eine wesentliche Forderung, die an Bindemittel von Positiv-Kopierschichten gestellt wird, nicht beriedigend erfüllen: die der Möglichkeit zur thermischen Selbstvernetzung. Diese Eigenschaft, die bei Novolaken gegeben ist, ist dann von Bedeutung, wenn die Kopierschicht aggresiven Chemikalien standzuhalten hat. In dieser Hinsicht ist auch bekannt, in die Polymeren Einheiten einzubauen, die zwar nicht alkalilöslich sind, aber die thermische Vernetzung ermöglichen (EP-A-0 184 044). Hierdurch werden jedoch andere Eigenschaften, wie etwa das Entwicklungsverhalten und die Lagerstabilität des Gemisches, beeinträchtigt.

Es war daher Aufgabe der Erfindung, ein positiv arbeitendes strahlungsempfindliches Gemisch zu schaffen, mit dem Flachdruckplatten mit höherer Druckauflagenleistung bzw. Photoresists mit verbessertem Wärmestand bereitgestellt werden können, und das ohne Beeinträchtigung des Lagerungsverhaltens thermisch vernetzbar ist.

Die Lösung dieser Aufgabe geht von einem strahlungsempfindlichen Gemisch der eingangs genannten Art aus und sie ist dadurch gekennzeichnet, daß das Gemisch als Bindemittel ein Polymeres mit Einheiten der allgemeinen Formel I

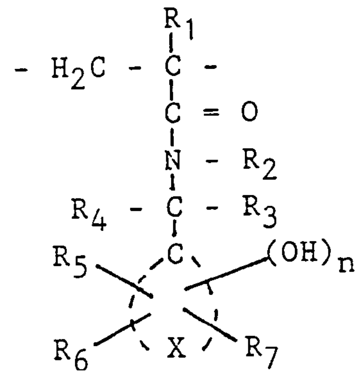

I

enthält, worin

| | |
|---|---|
| $R_1$ | ein Wasserstoff- oder Halogenatom, eine Cyanid- oder eine Alkylgruppe, |
| $R_2$, $R_3$, $R_4$ | gleich oder verschieden sind und Wasserstoff, Alkyl- oder Arylgruppen, |
| $R_5$, $R_6$ und ggf. $R_7$ | gleich oder verschieden sind und Wasserstoff- oder Halogenatome, Alkyl-, Aryl- oder Alkoxygruppen und |
| X | die zur Vervollständigung eines ein- oder mehrkernigen carbocyclischen aromatischen Ringsystems erforderlichen Atome bedeuten und |
| n | 1,2 oder 3 ist. |

In bevorzugter Ausführung enthält das Gemisch als Bindemittel ein Polymeres mit Einheiten der allgemeinen Formel I, wobei

| | |
|---|---|
| $R_1$ | ein Wasserstoff- oder Halogenatom, eine Cyanid- oder eine $C_1$ - $C_6$ Alkylgruppe, |
| $R_2$, $R_3$, $R_4$ | gleich oder verschieden sind und Wasserstoff oder $C_1$ - $C_6$ Alkylgruppen, |
| $R_5$, $R_6$ und ggf. $R_7$ | gleich oder verschieden sind und Wasserstoff oder $C_1$ - $C_4$ Alkylgruppen und |
| X | die zur Vervollständigung eines Benzol- oder Naphthalinrings erforderlichen Kohlenstoffatome |

bedeuten und

n 1 ist.

Besonders vorteilhaft ist ein Gemisch bei dem

| | |
|---|---|
| $R_1$ | Wasserstoff oder eine Methylgruppe, |
| $R_2$, $R_3$, $R_4$ | Wasserstoff, |
| $R_5$ | Wasserstoff, eine $C_1$ - $C_4$ Alkylgruppe oder ein Halogenatom, |
| $R_6$ | Wasserstoff, eine $C_1$ - $C_4$ Alkylgruppe, eine Arylgruppe oder Halogen, |
| $R_7$ | Wasserstoff und |
| X | die zur Vervollständigung eines Benzol- oder Naphthalinrings erforderlichen Kohlenstoffatome |

bedeuten und

n 1 ist.

Im Falle, daß $R_1$ eine Alkylgruppe ist, enthält diese im allgemeinen 1 bis 6, bevorzugt 1 oder 2 Kohlenstoffatome. Besonders bevorzugt werden Verbindungen, in denen $R_1$ ein Wasserstoffatom oder die Methylgruppe bedeutet.

Von den Substituenten $R_2$, $R_3$ und $R_4$ ist vorteilhaft einer ein Wasserstoffatom, vorzugsweise sind mindestens zwei Wasserstoffatome. Wenn diese Symbole Alkylgruppen bedeuten, haben diese in der Regel 1 bis 6, insbesondere 1 bis 3 Kohlenstoffatome.

Von den Substituenten $R_6$, $R_6$ und $R_7$ ist $R_6$ vorteilhaft eine Alkylgruppe mit 1 - 4 Kohlenstoffatomen, vorzugsweise eine Methylgruppe, $R_6$ eine Alkylgruppe mit 1 - 4 Kohlenstoffatomen oder eine Arylgruppe. $R_7$ ist bevorzugt ein Wasserstoffatom.

Allgemein sind hier unter Alkylgruppen verzweigte und unverzweigte, gesättigte und ungesättigte Gruppen mit cyclischen und offenen Ketten zu verstehen, die durch Halogenatome oder Hydroxygruppen substituiert sein oder Ether- oder Ketongruppen enthalten können. Bevorzugt werden unverzweigte Alkylgruppen mit 1 bis 4 Kohlenstoffatomen. Unter Arylgruppen sind hetero- oder carbocyclische aromatische Ringsysteme zu verstehen, die ein- oder mehrkernig, durch Aryl-, Alkoxy-, Hydroxygruppen oder Halogenatome substituiert sein können.

Die Position der beschriebenen Substituenten am Ringsystem X unterliegt keinerlei Beschränkungen, sie richtet sich lediglich nach der präparativen Zugänglichkeit der Verbindungen.

Das carbocyclische aromatische Ringsystem X kann einoder mehrkernig sein. Unter den carbocyclischen

Ringsystemen sind insbesondere Benzol- und Naphthalin-Systeme zu nennen.

Bevorzugte Beispiele für erfindungsgemäß eingesetzte Einheiten sind in den folgenden Formelbildern wiedergegeben:

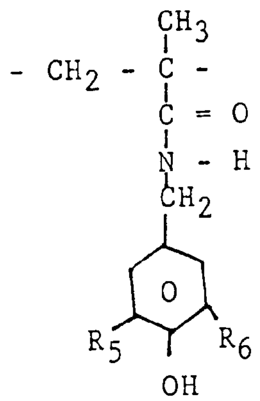

II

worin $R_5$ und $R_5$ gleich oder verschieden sind und Wasserstoff, $C_1$ - $C_4$ Alkyl oder Halogen bedeuten oder

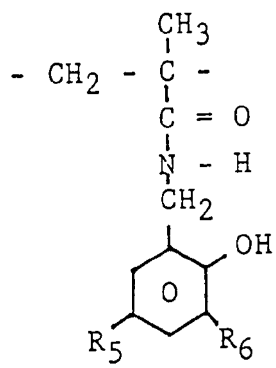

III

worin $R_5$ $C_1$ - $C_4$ Alkyl oder Halogen und $R_6$ $C_1$ - $C_4$ Alkyl, Halogen oder ein gegebenenfalls substituiertes Aryl bedeuten.

Die Darstellung der Monomeren mit Einheiten der Formel I erfolgt im allgemeinen durch säurekatalysierte Kondensationsreaktion von Alkoxymethyl- oder Hydroxymethylacrylamiden mit den aromatischen Ringsystemen. Dieses Verfahren und eine Vielzahl von Synthesebeispielen sind in CH-PS 476 689 und DE-PS 14 43 912 beschrieben.

Die Homopolymerisation der Monomeren mit Einheiten der Formel I oder deren Copolymerisation mit anderen Monomeren läßt sich nach konventionellen Methoden durchführen, beispielsweise in Gegenwart eines Polymerisationsinitiators wie Azo-bis-isobuttersäurenitril in organischen Lösungsmitteln wie Methylethylketon oder Ethanol bei erhöhten Temperaturen während eines Zeitraums von 1 bis 20 Stunden. Daneben ist aber auch eine Suspensions-, Emulsions- oder Massepolymerisation möglich, die auch durch Strahlung, Hitze oder ionische Initiatoren ausgelöst werden kann.

Die Polymeren mit Einheiten der Formel I können Homopolymerisate, welche ausschließlich Struktureinheiten der Formel I enthalten, oder Mischpolymerisate aus Monomeren entsprechend der Formel I und einem oder mehreren anderen Vinylmonomeren, gegebenenfalls auch mit phenolischen Gruppen, sein.

Weiterhin können verschiedene phenolgruppenhaltige Monomere der allgemeinen Formel I miteinander copolymerisiert werden, gegebenenfalls mit weiteren Vinylmonomeren.

Das Molekulargewicht der Homo- bzw. Copolymeren kann in weiten Grenzen variiert werden; bevorzugt werden Polymerisate mit $M_w$ = 1000 - 200.000, besonders solche mit $M_w$ = 5000 - 100.000. Die Hydroxylzahl liegt im allgemeinen im Bereich von 100 bis etwa 450, vorzugsweise zwischen 200 und 350.

Die Auswahl von geeigneten Homo- oder Copolymeren richtet sich im Einzelfall nach der Anwendung und nach der Art der übrigen Komponenten in der Kopierschicht.

Geeignete Comonomere werden durch Einheiten der allgemeinen Formel IV

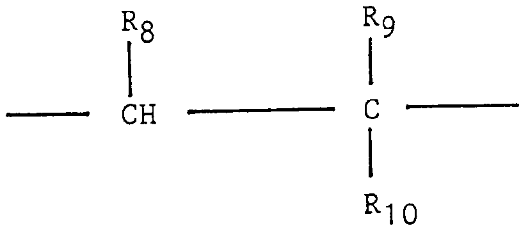

IV

wiedergegeben, worin

$R_8$ Wasserstoff oder eine Carboxylgruppe, die mit $R_9$, wenn letzteres eine Carboxylgruppe ist, zu einem Säureanhydrid oder einem ggf. substituierten Imid verbunden sein kann,

$R_9$ eine Alkyl-, Alkoxy-, Alkoxycarbonyl-, Acyl-, Acyloxy-, Aryl-, Aryloxycarbonyl-, Formyl-, Cyanid-, Carboxyl-, Hydroxyl- oder Aminocarbonylgruppe und

$R_{10}$ Wasserstoff, Halogen oder eine Alkylgruppe

bedeuten. Bevorzugt werden Einheiten berücksichtigt, in denen

$R_8$ Wasserstoff,

$R_9$ eine $C_1$ - $C_4$ Alkylgruppe, eine $C_1$ - $C_8$ Alkoxygruppe, eine Alkoxycarbonylgruppe mit 2 - 13 Kohlenstoffatomen, eine Acyloxygruppe mit 2 - 18 Kohlenstoffatomen, eine Arylgruppe mit 6 - 10 Kohlenstoffatomen oder eine Aryloxycarbonylgruppe mit 7 - 11 Kohlenstoffatomen, wobei die Arylgruppen durch Hydroxylgruppen substituiert sein können,

$R_{10}$ Wasserstoff oder eine Methylgruppe

bedeuten.

Wenn $R_9$ und $R_{10}$ Alkylgruppen sind, haben diese im allgemeinen 1 - 4 Kohlenstoffatome. Als Vertreter für $R_9$ kommen in Betracht: Alkoxygruppen mit 1 - 8 Kohlenstoffatomen, Alkoxycarbonylgruppen mit 2 - 13 Kohlenstoffatomen, Acyloxygruppen mit 2 - 18 Kohlenstoffatomen und Arylgruppen mit 6 - 10 Kohlenstoffatomen. Die Aminocarbonylgruppen können mit 1 - 8 Kohlenstoffatomen substituiert sein.

Beispiele für solche Verbindungen sind Styrol, α-Chlorstyrol, α-Methylstyrol, 2-, 3- oder 4-Chlormethylstyrol, 4-Bromstyrol, Methylvinylether, Ethylvinylether, Propylvinylether, Butylvinylether, Acrylnitril, Acrolein, Butadien, Acrylsäure, Methacrylsäure die Methyl- Ethyl-Propyl-, Butyl-, Pentyl-, Hexyl-, Octyl-, Decyl-, Dodecyl-, 2-Ethylhexyl-, Phenyl-, Benzyl-, Biphenyl-, Naphthylester dieser Säuren, Methacrylamid, Acrylamid, Vinylacetat, Vinylisobutylketon und Maleinsäureanhydrid. Besonders bevorzugte Comonomere besitzen folgende Einheiten

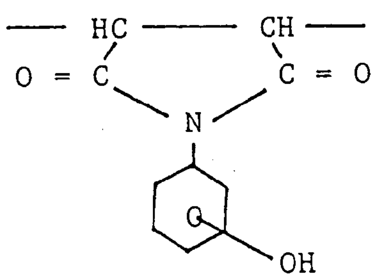

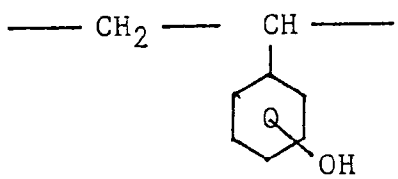

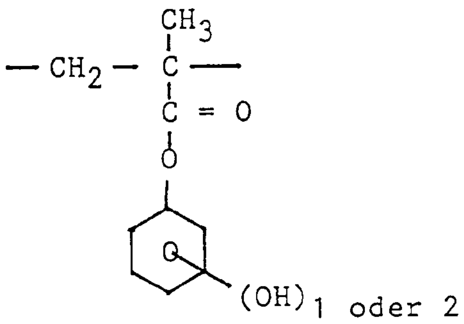

Der Gehalt an Einheiten der Formel I im Copolymeren richtet sich nach den übrigen Komponenten des Gemisches und nach der Anwendung. Im allgemeinen werden im erfindungsgemäßen Gemisch Polymere mit einem Gehalt von 10 bis 100, vorzugsweise 15 bis 80 Molprozent an gegebenenfalls verschiedenen Einheiten der Formel I eingesetzt.

Zur Herstellung der erfindungsgemäßen Gemische wird das beschriebene Bindemittel kombiniert mit lichtempfindlichen Verbindungen bzw. Gemischen, deren Löslichkeit in einer wäßrig-alkalischen Entwicklerlösung mit dem Belichten erhöht wird. Hierzu gehören 1 ,2-Chinondiazide und Kombinationen von photolytischen Säurespendern mit säurespaltbaren Verbindungen.

Als 1,2-Chinondiazide werden bevorzugt Naphthochinon(1,2)-diazid-(2)-4- oder -5-sulfonsäureester oder -amide verwendet. Von diesen werden die Ester, inbesondere die der 5-Sulfonsäuren, bevorzugt. Geeignete Verbindungen dieser Art sind bekannt und z.B. in der DE-AS 938 233, entsprechend GB-PS 739 654 beschrieben.

Die Menge von o-Chinondiazidverbindungen beträgt im allgemeinen 3 bis 50, bevorzugt 7 bis 35 Gewichtsprozent, bezogen auf die nichtflüchtigen Anteile des Gemisches.

Es ist auch möglich die 1,2-Chinondiazidverbindungen in Form ihrer Ester mit den erfindungsgemäßen Polymeren einzusetzen. Die Veresterung der entsprechenden 1,2-Chinondiazidsäurechloride mit den Hydroxylgruppen der zugrunde liegenden Polymeren erfolgt nach den in der Literatur bekannten Verfahren (DE-OS 2 507 548, entsprechend US-PS 4 139 384).

Auch Materialien auf Basis säurespaltbarer Verbindungen lassen sich mit gutem Effekt in dem erfindungsgemäßen Gemisch einsetzen.

Als durch Säure spaltbare Verbindungen sind in erster Linie zu nennen:

a) solche mit mindestens einer Orthocarbonsäureester- und bzw. oder Carbonsäureamidacetalgruppierung, wobei die Verbindungen auch polymeren Charakter haben und die genannten Gruppierungen als verknüpfende Elemente in der Hauptkette oder als seitenständige Substituenten auftreten können,

b) Oligomer- oder Polymerverbindungen mit wiederkehrenden Acetal- und/oder Ketalgruppierungen in der Hauptkette und

c) Verbindungen mit mindestens einer Enolether- oder N-Acylaminocarbonatgruppierung.

Durch Säure spaltbare Verbindungen des Typs a) als Komponenten strahlungsempfindlicher Gemische sind in der EP-A 0 022 571, entsprechend US-PS 4 311 782, ausführlich beschrieben; Gemische, die Verbindungen des Typs b) enthalten, sind in der DE-PS 23 06 248, entsprechend US-PS 3 779 778, und in der DE-PS 27 18 259, entsprechend US-PS 4 189 323, beschrieben; Verbindungen des Typs c) werden in EP-A 0 006 627, entsprechend US-PS 4 248 957, beschrieben.

Als strahlungsempfindliche Komponenten, die beim Belichten starke Säure bilden, sind eine große Anzahl von bekannten Verbindungen und Mischungen wie Phosphonium-, Sulfonium- und Jodoniumsalze, Halogenverbindungen und Organometall-Organohalogen-Kombinationen geeignet.

Die genannten Phosphonium-, Sulfonium-und Jodoniumverbindungen werden in der Regel eingesetzt in Form ihrer in organischen Lösemitteln löslichen Salze, meist als Abscheidungsprodukt mit komplexen Säuren wie Borfluorwasserstoffsäure, Hexafluorphosphor-, Hexafluorantimon- und -arsensäure.

Grundsätzlich sind als halogenhaltige strahlungsempfindliche und Halogenwasserstoffsäure bildende Verbindungen alle auch als photochemische Radikalstarter bekannten organischen Halogenverbindungen, beispielsweise solche mit mindestens einem Halogenatom an einem Kohlenstoffatom oder an einem aromatischen Ring brauchbar (US-PS 3 515 552). Von diesen Verbindungen werden die s-Triazinderivate mit 2 Halogenmethylgruppen, insbesondere Trichlormethylgruppen und einem aromatischen bzw. ungesättigten Substituenten im Triazinkern, wie sie in DE-PS 27 18 259, entsprechend US-PS 4 189 323 beschrieben sind, bevorzugt. Ebenso gut geeignet sind 2-Trichlormethyl-1 ,3,4-oxdiazole. Die Wirkung dieser halogenhaltigen Verbindungen kann auch durch bekannte Sensibilisatoren spektral beeinflußt und gesteigert werden.

Beispiele für geeignete photochemische Säurespender sind:

4-methyl-6-trichlormethyl-2-pyron, 4-(3,4,5-Trimethoxystyryl)-6-trichlormethyl-2-pyron, 4-(4-Methoxystyryl)-6-(3,3,3-trichlorpropenyl)-2-pyron, 2-Trichlormethylbenzimidazol, 2-Tribrommethylchinolin, 2,4-Dimethyl-1-tribromacetyl-benzol, 3-Nitro-1-tribromacetyl-benzol, 4-Dibromacetyl-benzoesäure, 1,4-Bis-dibrommethyl-benzol, Tris-dibrommethyl-s-triazin, 2-(6-Methoxy-naphth-2-yl)-, 2-(Naphth-1-yl)-, 2-(4-Ethoxyethylnaphth-1-yl)-, 2-(Benzo-pyran-3-yl)-, 2-(4-Methoxyanthrac-1-yl)-, 2-(4-Styrylphenyl)-, 2-(Phenanthr-9-yl)-4,6-bis-trichlormethyl-s-triazin und die in den Beispielen aufgeführten Verbindungen.

Die Menge des photochemischen Säurespenders kann je nach seiner chemischen Natur und der Zusammensetzung der Schicht ebenfalls sehr verschieden sein. Günstige Ergebnisse werden erhalten mit etwa 0,5 bis zu 20 Gewichtsprozent, bezogen auf den Gesamtfeststoff. Bevorzugt sind 0,1 bis 12 Gewichtsprozent. Besonders für lichtempfindliche Schichten von Dicken über 0,01 mm empfiehlt es sich, relativ wenig Säurespender zu verwenden.

Zusätzlich können noch zahlreiche andere Oligomere und Polymere mitverwendet werden, z.B. Phenolharze vom Novolaktyp oder Vinylpolymerisate wie Polyvinylacetale, Polymethacrylate, Polyacrylate, Polyvinylether und Polyvinylpyrrolidone, die selbst durch Comonomere modifiziert sein können.

Der günstigste Anteil an diesen Zusätzen richtet sich nach den anwendungstechnischen Erfordernissen und dem Einfluß auf die Entwicklungsbedingungen und beträgt im allgemeinen nicht mehr als 20 Gewichtsprozent vom erfindungsgemäß eingesetzten Polymerisat. In geringen Mengen kann die strahlungsempfindliche Schicht für spezielle Erfordernisse wie Flexibilität, Haftung, Glanz etc. außerdem noch Substanzen wie Polyglykole, Celluloseether, z.B. Ethylcellulose, Netzmittel und feinteilige Pigmente enthalten.

Ferner können dem strahlungsempfindlichen Gemisch noch lösliche oder auch feinteilige dispergierbare Farbstoffe sowie, je nach Anwendungszweck, auch UV-Absorber zugesetzt werden. Als Farbstoffe haben sich die Triphenylmethanfarbstoffe, insbesondere in der Form ihrer Carbinolbasen, besonders bewährt. Die günstigsten Mengenverhältnisse der Komponenten lassen sich im Einzelfall durch Vorversuche leicht ermitteln.

Die Erfindung betrifft auch ein strahlungsempfindliches Aufzeichnungsmaterial mit einem Schichtträger und einer strahlungsempfindlichen Aufzeichnungsschicht, die als wesentlichen Bestandteil ein Gemisch nach Anspruch 1 enthält.

Zur Beschichtung eines geeigneten Schichtträgers werden die Gemische im allgemeinen in einem Lösungsmittel gelöst. Die Wahl der Lösungsmittel ist auf das vorgesehene Beschichtungsverfahren, die Schichtdicke und die Trocknungsbedingungen abzustimmen. Geeignete Lösungsmittel für das erfindungsgemäße Gemisch sind Ketone, wie Methylethylketon, chlorierte Kohlenwasserstoffe, wie Trichlorethylen und 1,1,1-Trichlorethan, Alkohole wie n-Propanol, Ether wie Tetrahydrofuran, Alkoholether wie Ethylenglykol-monoethylether, Propylenglykolmonomethylether und Ester wie Butylacetat. Es können auch Gemische verwendet werden, die zudem noch für spezielle Zwecke Lösungsmittel wie Acetonitril, Dioxan oder Dimethylformamid enthalten können. Prinzipiell sind alle Lösungsmittel verwendbar, die mit den Schichtkomponenten nicht irreversibel reagieren. Partialether von Glykolen, insbesondere Ethylenglykolmonomethylether und Propylenglykolmonomethylether allein oder im Gemisch werden besonders bevorzugt.

Als Schichtträger für Schichtdicken unter ca. 10 μm werden meist Metalle verwendet. Für Offsetdruckplatten können eingesetzt werden: walzblankes, mechanisch und/oder elektrochemisch aufgerauhtes und gegebenenfalls anodisiertes Aluminium, das zudem noch chemisch, z.B. mit Polyvinylphosphonsäure, Silikaten, Phosphaten, Hexafluorozirkonaten oder mit hydrolysiertem Tetraethylorthosilikat vorbehandelt sein kann.

Die Beschichtung des Schichtträgers erfolgt in bekannter Weise durch Aufschleudern, Sprühen, Tauchen, Walzen mittels Breitschlitzdüsen, Rakeln oder durch Gießer-Antrag.

Zum Belichten können die üblichen Lichtquellen wie Röhrenlampen, Xenonimpulslampen, metallhalogeniddotierte Quecksilberdampf-Hochdrucklampen und Kohlenbogenlampen verwendet werden.

Unter Belichtung bzw. Bestrahlung ist in dieser Beschreibung die Einwirkung aktinischer elektromagnetischer Strahlung in Wellenlängenbereichen unterhalb etwa 500 nm zu verstehen. Alle in diesem Wellenlängenbereich emittierenden Strahlungsquellen sind prinzipiell geeignet.

Mit Vorteil können auch Laserbestrahlungsgeräte, insbesondere automatische Verarbeitungsanlagen verwendet werden, die als Strahlungsquelle einen Argon- oder Krypton-Ionen-Laser enthalten.

Die Bestrahlung kann auch mit Elektronenstrahlen erfolgen. In diesem Falle können auch im üblichen Sinne nicht lichtempfindliche Säure bildende Verbindungen als Initiatoren der Solubilisierungsreaktion eingesetzt werden, z.B. halogenierte aromatische Verbindungen oder halogenierte polymere Kohlenwasserstoffe. Auch Röntgenstrahlen können zur Bilderzeugung verwendet werden.

Die bildmäßig belichtete oder bestrahlte Schicht kann in bekannter Weise mit praktisch den gleichen Entwicklern, wie sie für handelsübliche Naphthochinondiazid-Schichten und Kopierlacke bekannt sind, entfernt werden, oder die neuen Materialien können in ihrem Kopierverhalten mit Vorteil auf die bekannten Hilfsmittel wie Entwickler und programmierte Sprühentwicklungsgeräte abgestimmt werden. Die wäßrigen Entwicklerlösungen können z.B. Alkaliphosphate, -silikate oder -hydroxide und ferner Netzmittel sowie gegebenenfalls kleinere Anteile organischer Lösungsmittel enthalten. In bestimmten Fällen sind auch Lösungsmittel-Wasser-Gemische als Entwickler brauchbar. Die Wahl des günstigsten Entwicklers kann durch Versuche mit der jeweils verwendeten Schicht ermittelt werden. Bei Bedarf kann die Entwicklung mechanisch unterstützt werden. Bei der Anwendung als Druckplatten können zur Erhöhung der Widerstandsfähigkeit beim Druck sowie der Resistenz gegen Auswaschmittel, Korrekturmittel und durch UV-Licht härtbare Druckfarben die entwickelten Platten kurzzeitig auf erhöhte Temperaturen erwärmt werden, wie es für Diazoschichten aus der GB-PS 1 154 749 bekannt ist.

Durch die Erfindung wird erreicht, daß man nunmehr strahlungsempfindliche Gemische und Aufzeichnungsmaterialien zur Verfügung stellen kann, die eine gute Lagerfähigkeit besitzen, mit denen in hoher Auflage gedruckt werden kann, bei der Verwendung als Photoresist einen hervorragenden Wärmestand aufweisen, die thermisch nachgehärtet werden können und nach der Nachhärtung gegenüber den bekannten Materialien eine bessere Chemikalienbeständigkeit besitzen.

Im folgenden werden Beispiele für bevorzugte Ausführungsformen angegeben. In den Beispielen stehen Gewichtsteile (Gt) und Volumenteile (Vt) im Verhältnis von g zu ccm. Prozent- und Mengenverhältnisse sind, wenn nichts anderes angegeben ist, in Gewichtseinheiten zu verstehen.

Synthesebeispiel 1 zur Herstellung der Monomeren

129 g (1 mol) N-Methoxymethylmethacrylamid
122 g (1 mol) 2.6-Dimethylphenol
0,1 g (0,5 mmol) Thiodiphenylamin
1 g (0,01 mol) Schwefelsäure

werden in 114 g Ethanol gelöst und für 5 Stunden zum Rückfluß erhitzt. Nach Abkühlen der Reaktionslösung auf 10 °C kristallisiert das Produkt aus, wird abfiltriert und bei 50 °C im Vakuum getrocknet. Es resultieren 178 g (81 %) 3,5-Dimethyl-4-hydroxybenzylmethacrylamid, Fp. 135 - 136 °C.

Tabelle 1 gibt eine Reihe von bevorzugten Monomeren wieder, die entsprechend dieser Vorschrift zugänglich sind. Weitere Beispiele können CH-PS 476 689 und DE-PS 1 443 912 entnommen werden.

Tabelle 1

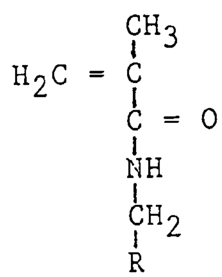

| Monomer Nr. | R | Ausbeute (%) | Fp (°C) |
|---|---|---|---|
| 1 | 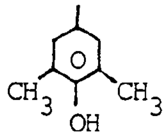 | 81 | 135-136 |
| 2 | 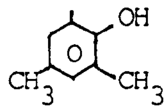 | 75 | 109-110 |
| 3 | 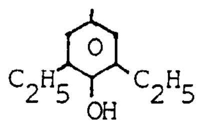 | 71 | 117-118 |
| 4 | 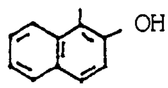 | 48 | 151-152 |

Synthesebeispiel 2 zur Herstellung der Polymeren

1 mol des Monomeren oder Monomergemisches (vgl. Tabelle 2) und
0,015 mol Azo-bis-isobuttersäurenitril

werden in Ethanol oder Butanon oder Tetrahydrofuran zu einer Ansatzlösung mit einem Feststoffgehalt von 40 % vereint und 17 Stunden bei 70 °C unter Stickstoff-Inertisierung polymerisiert. Dann wird unter starkem Rühren in das 25-fache Volumen Wasser eingetragen. Das ausgefallene Polymere wird bei 50 °C 48 Stunden im Vakuum getrocknet. In Tabelle 2 sind die auf diesem Wege hergestellten Polymeren zusammengefaßt.

Tabelle 2

| Polymer Nr. | Monomer Nr. (Mol %) | | Comonomer 1 (Mol%) | | Comonomer 2 (Mol%) | | reduzierte Viskosität $\frac{dl}{g}$ |
|---|---|---|---|---|---|---|---|
| 1 | 1 | 100 | - | | - | | 0,176 |
| 2 | 2 | 100 | - | | - | | 0,188 |
| 3 | 3 | 100 | - | | - | | 0,173 |
| 4 | 4 | 100 | - | | - | | 0,191 |
| 5 | 1 | 65 | Styrol | 10 | Methylmethacrylat | 25 | 0,133 |
| 6 | 2 | 65 | Styrol | 10 | Methylmethacrylat | 25 | 0,124 |
| 7 | 1 | 25 | 2-Hydroxyphenylmethacrylat | 46 | Styrol | 29 | 0,197 |
| 8 | 1 | 20 | 2-Hydroxyphenylmethacrylat | 51 | Styrol | 29 | 0,209 |
| 9 | 1 | 15 | 2-Hydroxyphenylmethacrylat | 56 | Styrol | 29 | 0,199 |
| 10 (Vergleich) | - | - | 2-Hydroxyphenylmethacrylat | 100 | - | - | 0,211 |

Das Polymer 10 entspricht einer aus EP-A 0 212 440 bekannten Substanz.

Synthesebeispiel 3 zur Herstellung eines Polymeren mit Hydroxyphenylmaleinsäureimideinheiten

1 mol des Monomergemisches (wobei Hydroxyphenylmaleinsäureimid in der acetylierten Form eingesetzt wird)

0,015 mol Azo-bis-isobuttersäurenitril

werden in Butanon oder Tetrahydrofuran zu einer Ansatzlösung mit einem Feststoffgehalt von 35 % vereint und wie in Synthesebeispiel 2 polymerisiert. Dann gibt man die 5-fache molare Menge Methanol (bezogen auf acetyliertes Hydroxyphenylmaleinsäureimid) und eine katalytische Menge Schwefelsäure zu und destilliert dann das sich bildende Methylacetat zusammen mit dem Überschuß an Methanol langsam ab. Die Isolierung des Polymeren erfolgt durch Ausfällen des Polymeren in Methanol/Wasser (1:1). Die nach diesem Verfahren synthesierten Polymeren sind in Tabelle 3 aufgeführt (Nr. 17 und 18).

Synthesebeispiel 4 zur Herstellung eines Polymeren mit Hydroxystyrol als Comonomer

1 mol des Monomergemisches (wobei Hydroxystyrol in der acetylierten Form eingesetzt wird)
0,015 mol Azo-bis-isobuttersäurenitril

werden in Ethanol zu einer Ansatzlösung mit einem Feststoffgehalt von 40 % vereint und wie in Synthesebeispiel 2 polymerisiert. Dann gibt man NaOH (15 mol% bezogen auf Acetoxystyrol) 10 %ig in Methanol zu und verseift 5 Stunden bei 60 °C. Dann gibt man HCl (15 mol%, bezogen auf Acetoxystyrol) als 37 %ige wäßrige Lösung zu und läßt unter Rühren abkühlen. Die Isolierung des Polymeren erfolgt wie in Synthesebeispiel 2 beschrieben. Die in Tabelle 3 aufgeführten Polymeren 11 - 16 wurden nach diesem Verfahren hergestellt.

Synthesebeispiel 5 zur Herstellung eines Polymeren mit seitenständigen 1,2-Chinondiazideinheiten

21,9 g Polymer Nr. 1 und
5,37 g (0,02 mol) 1,2-Naphthochinon-2-diazid-5-sulfonylchlorid

werden in 250 ml Tetrahydrofuran gelöst und unter Rühren und Kühlen 2g (0,02 mol) Triethylamin in 10 ml Tetrahydrofuran so zugetropft, daß die Temperatur 25°C nicht übersteigt. Es wird noch 2 Stunden bei Raumtemperatur nachgerührt und dann in 3 l 4 %ige Salzsäure ausgefällt. Das Produkt wird abfiltriert und bei Raumtemperatur im Vakuumtrockenschrank bis zur Gewichtskonstanz getrocknet. Aus dem Schwefelgehalt des Polymeren errechnet sich ein Umsatz von 97,1 %.

Wiederholt man die Reaktion mit 1,2-Napthochinon-2-diazid-4-sulfonylchlorid, so resultiert ein Polymer mit einem Gehalt an 1,2-Chinondiazideinheiten von 93,7 % der Theorie.

Tabelle 3

| Polymer Nr. | Monomer Nr. | Monomer (Mol %) | Comonomer 1 | Comonomer 1 (Mol%) | Comonomer 2 | Comonomer 2 (Mol%) | reduzierte Viskosität $\frac{dl}{g}$ |
|---|---|---|---|---|---|---|---|
| 11 | 1 | 15 | 4-Hydroxystyrol | 40 | Styrol | 45 | 0,198 |
| 12 | 2 | 15 | 4-Hydroxystyrol | 40 | Styrol | 45 | 0,203 |
| 13 | 3 | 15 | 4-Hydroxystyrol | 40 | Styrol | 45 | 0,201 |
| 14 | 4 | 15 | 4-Hydroxystyrol | 42 | Styrol | 43 | 0,227 |
| 15 | 1 | 15 | 4-Hydroxystyrol | 35 | Methylmethacrylat | 50 | 0,385 |
| 16 (Vergleich) | - | - | 4-Hydroxystyrol | 100 | - | - | 0,205 |
| 17 | 1 | 15 | 4-Hydroxyphenylmaleinsäureimid | 40 | Styrol | 45 | 0,591 |
| 18 (Vergleich) | - | - | 4-Hydroxyphenylmaleinsäureimid | 50 | Styrol | 50 | 0,721 |

Das Polymer 16 entspricht einer bekannten Substanz aus DE-OS 34 06 927, das Polymer 18 einer Substanz aus EP-A 0 187 517.

Beispiel 1

Eine in Salzsäure elektrolytisch aufgerauhte, in Schwefelsäure anodisierte und mit Polyvinylphosphonsäure hydrophilierte Aluminiumplatte wird mit folgender Lösung schleuderbeschichtet:

7 Gt (Gewichtsteile) Bindemittel (vgl. Tabelle 4),

1,5 Gt eines Veresterungsproduktes aus 3 mol 1,2-Naphthochinon- (2)-diazid-4-sulfonylchlorid und 1 mol 2,3,4-Trihydroxybenzophenon,

0,2 Gt 1,2-Naphthochinon-(2)-diazid-4-sulfonylchlorid,

0,08 Gt Victoriareinblau (Basic Blue 7 C.I. 42 595),

100 Gt eines Lösungsmittelgemisches aus Tetrahydrofuran und Propylenglykolmonomethylether (55 : 45).

Nach 2-minütigem Trocknen bei 100 °C resultiert eine Schichtdicke von 2 µm.

Die Druckplatten werden unter einer 5-kW-Metallhalogenidlampe im Abstand von 110 cm durch einen Halbtonstufenkeil mit 13 Dichtestufen von je 0,15 (Belichtungskeil "BK 01" der Hoechst AG) so belichtet, daß nach einer Entwicklungszeit von 60 Sekunden (s) in einem der folgenden Entwickler eine offene Stufe 3 erhalten wird:

Entwickler A:

8,5 Gt $Na_2SiO_3$ x 9 $H_2O$,
0,8 Gt NaOH und
1,5 Gt $Na_2B_4O_7$ x 10 $H_2O$ in
89,2 Gt $H_2O$

Entwickler B:

5,3 Gt Natriummetasilikat x 9 $H_2O$,
3,4 Gt Trinatriumphosphat x 12 $H_2O$,
0,3 Gt Natriumhydrogenphosphat (wasserfrei),
91,0 Gt Wasser.

Anschließend werden die Platten mit einer handelsüblichen Einbrenngummierung (zum Beispiel RC 99 der Hoechst AG) überwischt und 5 Minuten bei 230 °C in einem Lacktrockenschrank eingebrannt. Mit Dimethylformamid wird die Chemikalienresistenz der eingebrannten Platten geprüft.

Tabelle 4

| Beispiel Nr. | Polymer Nr. | Belichtungszeit (s) | Entwickler | Chemikalienresistenz nach dem Einbrennen |
|---|---|---|---|---|
| 1 - 1 | 1 | 65 | B | + |
| 1 - 2 | 2 | 65 | B | + |
| 1 - 3 | 3 | 65 | B | + |
| 1 - 4 | 4 | 68 | A | + |
| 1 - 5 | 5 | 62 | A | + |
| 1 - 6 | 6 | 62 | A | + |
| 1 - 7 | 7 | 60 | A | + |
| 1 - 8 | 8 | 60 | A | + |
| 1 - 9 | 9 | 60 | A | + |
| 1 - 10 | 10 (Vergl.) | 60 | B | - |
| 1 - 11 | 11 | 58 | A | + |
| 1 - 12 | 12 | 58 | A | + |
| 1 - 13 | 13 | 58 | A | + |
| 1 - 14 | 14 | 60 | A | + |
| 1 - 15 | 15 | 56 | A | + |
| 1 - 16 | 16 (Vergl.) | 55 | B | - |
| 1 - 17 | 17 | 62 | B | + |
| 1 - 18 | 18 (Vergl.) | 58 | B | - |
| 1 - 19 | m-Kresol-Formaldehyd-Novolak (Vergleich) | 62 | A | + |

Von einer Reihe dieser Platten wurden im nicht thermisch gehärteten Zustand Druckversuche in einer Bogenoffsetmaschine durchgeführt. Tabelle 5 gibt die Ergebnisse wieder.

Tabelle 5

| Beispiel Nr. | Polymer | Druck-auflage | Glasübergangstemperaturen der Polymeren |
|---|---|---|---|
| 1 - 5 | 5 | 150.000 | 136 °C |
| 1 - 7 | 7 | 160.000 | 134 °C |
| 1 - 10 (Vergleich) | 10 | 160.000 | 132 °C |
| 1 - 16 (Vergleich) | 16 | 140.000 | 154 °C |
| 1 - 18 (Vergleich) | 18 | 130.000 | 238 °C |
| 1 - 19 (Vergleich) | m-Kresol-Formaldehyd-Novolak | 90.000 | 84 °C |

Die Ergebnisse zeigen, daß die erfindungsgemäßen polymeren Druckplattenkopierschichten eine höhere Druckauflage als herkömmliche Positivkopierschichten mit Novolaken als Bindemittel ergeben und daß sie durch thermische Nachhärtung resistent gegen aggressive Chemikalien werden.

Beispiel 2

Zur Herstellung eines Positivtrockenresists werden Beschichtungslösungen hergestellt aus:

| | | | |
|---|---|---|---|
| 40 | Gt | Bindemittel, | vergleiche Tabelle 6 |
| 10 | Gt | einer Verbindung mit säurespaltbaren C-O-C-Einheiten, | |
| 0,5 | Gt | photochemischen Säurebildners, | |
| 6,0 | Gt | Polyethylacrylat, | |
| 0,01 | Gt | Kristallviolett-Base (C.I. 42 555:1), | |
| 100 | Gt | Butanon. | |

Diese Lösungen werden jeweils auf 26 µm dicke, biaxial gestreckte und thermofixierte Polyethylenterephthalatfolien aufgeschleudert und anschließend 10 Minuten bei 100 °C im Umlufttrockenschrank nachgetrocknet. Die Umdrehungszahl der Schleuder wird so reguliert, daß eine Schichtdicke von ca. 25 µm resultiert. Zum Schutz gegen Staub und Verkratzungen wird darauf noch eine Polyethylenfolie als Deckfolie kaschiert.

Zur Herstellung von Leiterplatten werden die Trockenresists nach Abziehen der Deckfolie in einem handelsüblichen Laminator auf einen gereinigten, vorgewärmten Träger, der aus einem Isoliermaterial mit ein- oder beidseitiger, 35 µm dicker Kupferauflage besteht, laminiert. Nach Abziehen der Trägerfolie und eventuellem Nachtrocknen wird unter einer Vorlage mit einer 5-kW-Metallhalogenidlampe in 110 cm Abstand belichtet und nach einer Wartezeit von 15 Minuten in 1%iger Natronlauge 90 Sekunden entwickelt.

Die auf diese Weise entstandenen Resistschablonen weisen eine hervorragende Galvanoresistenz auf, insbesondere bei dem galvanischen Aufbau von Kupfer und Pb/Sn-Legierungen.

Derartig behandelte Platten lassen sich anschließend erneut belichten und entwickeln. Mit dieser Arbeitsweise lassen sich in einem ersten Schritt Lötaugen aus Pb/Sn an den Bohrlöchern aufgalvanisieren, in einem zweiten Belichtungs- und Entwicklungsschritt läßt sich dann das Leiterbahnbild auf die noch bestehende Resistschicht übertragen. Nach dem Ätzen des freigelegten Kupfers mit ammoniakalischer Cu(II)-chlorid-Lösung erhält man eine Leiterplatte in Kupfertechnik, d. h., die Pb/Sn-Legierung wird nur dort aufgebaut, wo sie beim nachfolgenden Lötprozeß benötigt wird.

Die Ergebnisse sind in Tabelle 6 aufgezeigt. Folgende Verbindungen mit säurespaltbaren C-O-C-Einheiten wurden eingesetzt:

Nr. 1 : polymerer Orthoester, hergestellt durch Kondensation von Orthoameisensäuretrimethylester mit 4-Oxa-6,6-bis-hydroxymethyl-octan-1-ol,

Nr. 2: Polyacetal, hergestellt aus Triethylglykol und 2-Ethylbutyraldehyd.

Folgende photochemischen Säurebildner wurden verwendet:

Nr. 1 : 2-(4-Ethoxy-naphth-1-yl)-4,6-bis-trichlormethyl-s-triazin,

Nr. 2: 2-(4-Styrylphenyl)-4,6-bis-trichlormethyl-s-triazin.

Tabelle 6

| Beispiel Nr. | Polymer Nr. | säurespaltbare Verbindung Nr. | photochemischer Säurebildner Nr. | Belichtungszeit (s) |
|---|---|---|---|---|
| 2 - 1 | 5 | 1 | 1 | 25 |
| 2 - 2 | 5 | 1 | 2 | 23 |
| 2 - 3 | 5 | 2 | 1 | 27 |
| 2 - 4 | 5 | 2 | 2 | 25 |
| 2 - 5 | 7 | 2 | 2 | 23 |
| 2 - 6 | 11 | 2 | 2 | 21 |
| 2 - 7 | 15 | 2 | 2 | 20 |

Beispiel 3

Zur Herstellung hochauflösender Positiv-Flüssigresists werden folgende Beschichtungslösungen hergestellt:

26 Gt Bindemittel (vgl. Tabelle 7),

4 Gt eines Veresterungsproduktes aus 3 mol 1,2-Naphthochinon-(2)-diazid-4-sulfonylchlorid und 1 mol 2,3,4-Trihydroxybenzophenon,

80 Gt Propylenglykolmonomethyletheracetat.

Nach Filtration durch ein Filter mit Porendurchmesser von 0,2 µm (Millipore) werden die Photoresistlösungen auf käufliche, wie üblich polierte und durch Oxidation mit einer 0,2 µm dicken $SiO_2$-Schicht versehene Siliciumscheiben geschleudert. Bei einer Umdrehungszahl von 8000/min werden Schichtdicken zwischen 0,9 und 1,1 µm erhalten.

Die so beschichteten Scheiben werden 30 Minuten bei 90 °C getrocknet. Nach dem Abkühlen und Konditionieren auf ein definiertes Raumklima von 23 °C und 40 bis 50 % relativer Feuchte werden die Wafer in einem Kontaktbelichtungsgerät mit einer Intensität von 4,5 $mW/cm^2$ bei 365 nm unter einer handelsüblichen Chrommaske belichtet und 60 Sekunden in einer 2,86%igen Tetramethylammonium-hydroxidlösung entwickelt. In allen Fällen ist eine Wiedergabe von 1-µm-Linien und -Spalten möglich.

Nach einer Wärmebehandlung von 30 Minuten bei 150 °C werden die Flanken der Strukturen beurteilt. In Tabelle 7 sind die Ergebnisse dargelegt.

Tabelle 7

| Beispiel Nr. | Polymer Nr. | Belichtungszeit (s) | Flankenstruktur nach Wärmebehandlung |
|---|---|---|---|
| 3 - 1 | 4 | 25 | fast unverändert |
| 3 - 2 | 5 | 20 | leichte Rundungen |
| 3 - 3 | 7 | 20 | leichte Rundungen |
| 3 - 4 | 14 | 20 | leichte Rundungen |
| 3 - 5 | 17 | 20 | fast unverändert |
| 3 - 6 | m-Kresol-Formaldehyd-Novolak (Vergleich) | | starke Rundungen |

**Patentansprüche**

1. Positiv arbeitendes strahlungsempfindliches Gemisch, das als wesentliche Bestandteile
   a) ein in Wasser unlösliches, in wäßrig-alkalischen Lösungen lösliches polymeres Bindemittel und
   b) ein 1,2-Chinondiazid oder eine Kombination aus
      1) einer unter Einwirkung von aktinischer Strahlung starke Säure bildenden Verbindung und
      2) einer Verbindung mit mindestens einer spaltbaren C-O-C-Bindung

   enthält, dadurch gekennzeichnet, daß das Gemisch als Bindemittel ein thermisch selbstvernetzendes Polymeres mit Einheiten der allgemeinen Formel I

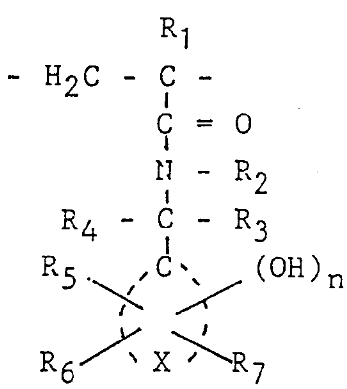

I

   enthält, worin

   $R_1$ ein Wasserstoff- oder Halogenatom, eine Cyanid- oder eine Alkylgruppe,

| | |
|---|---|
| $R_2$, $R_3$ $R_4$ | gleich oder verschieden sind und Wasserstoff Alkyl- oder Arylgruppen, |
| $R_5$, $R_6$ und ggf. $R_7$ | gleich oder verschieden sind und Wasserstoffoder Halogenatome, Alkyl-, Aryl- oder Alkoxygruppen und |
| X | die zur Vervollständigung eines ein- oder mehrkernigen carbocyclischen aromatischen Ringsystems erforderlichen Atome bedeuten und |
| n | 1,2 oder 3 ist. |

**2.** Gemisch nach Anspruch 1, dadurch gekennzeichnet, daß

| | |
|---|---|
| $R_1$ | ein Wasserstoff- oder Halogenatom, eine Cyanid- oder eine $C_1$-$C_6$ Alkylgruppe, |
| $R_2$, $R_3$, $R_4$ | gleich oder verschieden sind und Wasserstoff oder $C_1$-$C_6$ Alkylgruppen, |
| $R_5$, $R_6$ und ggf. $R_7$ | gleich oder verschieden sind und Wasserstoff oder $C_1$-$C_4$ Alkylgruppen und |
| X | die zur Vervollständigung eines Benzol- oder Naphthalinrings erforderlichen Kohlenstoffatome |

bedeuten und
n 1 ist.

**3.** Gemisch nach Anspruch 1 oder 2, dadurch gekennzeichnet, daß

| | |
|---|---|
| $R_1$ | ein Wasserstoff oder eine Methylgruppe, |
| $R_2$, $R_3$, $R_4$ | Wasserstoff, |
| $R_5$ | Wasserstoff, eine $C_1$-$C_4$ Alkylgruppe oder Halogen, |
| $R_6$ | Wasserstoff, eine $C_1$-$C_4$ Alkylgruppe, eine Arylgruppe oder Halogen, |
| $R_7$ | Wasserstoff, |
| X | die zur Vervollständigung eines Benzol- oder Naphthalinrings erforderlichen Kohlenstoffatome |

bedeuten und
n 1 ist.

**4.** Gemisch nach Ansprüchen 1 bis 3, dadurch gekennzeichnet, daß das Gemisch als Bindemittel ein Polymeres enthält mit Einheiten der allgemeinen Formel II

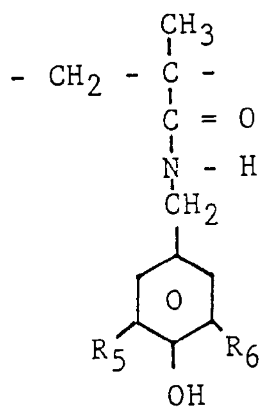

II

worin
$R_5$ und $R_6$ gleich oder verschieden sind und Wasserstoff, $C_1$-$C_4$ Alkyl oder Halogen bedeuten.

**5.** Gemisch nach Ansprüchen 1 bis 3, dadurch gekennzeichnet, daß das Gemisch als Bindemittel ein Polymeres enthält mit Einheiten der allgemeinen Formel III

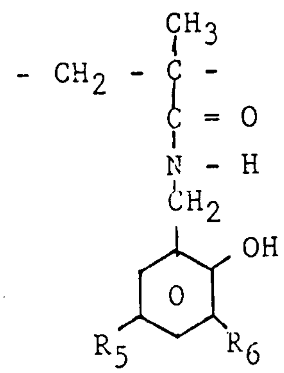

III

worin

$R_5$ $C_1$-$C_4$ Alkyl oder Halogen und

$R_6$ $C_1$-$C_4$ Alkyl, Halogen oder ein ggf. substituiertes Aryl

bedeuten.

6. Gemisch nach Anspruch 1, dadurch gekennzeichnet, daß das polymere Bindemittel ferner eine oder mehrere verschiedene wiederkehrende Einheiten der allgemeinen Formel IV

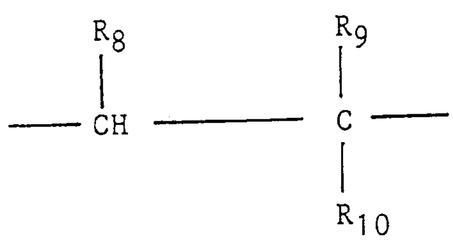

IV

enthält, worin

$R_8$ Wasserstoff oder eine Carboxylgruppe, die mit $R_9$, wenn letzteres eine Carboxylgruppe ist, zu einem Säureanhydrid oder einem ggf. substituierten Imid verbunden sein kann,

$R_9$ eine Alkyl-, Alkoxy-, Alkoxycarbonyl-, Acyl-, Acyloxy-, Aryl-, Aryloxycarbonyl-, Formyl-, Cyanid-, Carboxyl-, Hydroxyl- oder Aminocarbonylgruppe und

$R_{10}$ Wasserstoff, Halogen oder eine Alkylgruppe

bedeuten.

7. Gemisch nach Anspruch 6, dadurch gekennzeichnet, daß

$R_8$ Wasserstoff,

$R_9$ eine $C_1$-$C_4$ Alkylgruppe, eine $C_1$-$C_8$ Alkoxygruppe, eine Alkoxycarbonylgruppe mit 2 - 13 Kohlenstoffatomen, eine Acyloxygruppe mit 2 - 18 Kohlenstoffatomen, eine Arylgruppe mit 6 - 10 Kohlenstoffatomen oder eine Aryloxycarbonylgruppe mit 7 - 11 Kohlenstoffatomen, wobei die Arylgruppen durch Hydroxylgruppen substituiert sein können, und

$R_{10}$ Wasserstoff oder eine Methylgruppe

bedeuten.

8. Gemisch nach Anspruch 6, dadurch gekennzeichnet, daß Formel IV für eine der folgenden Einheiten steht:

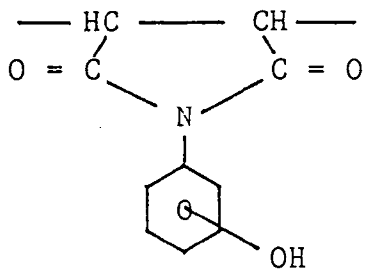

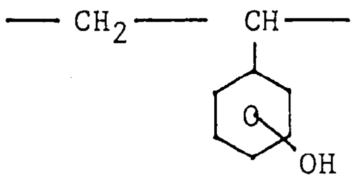

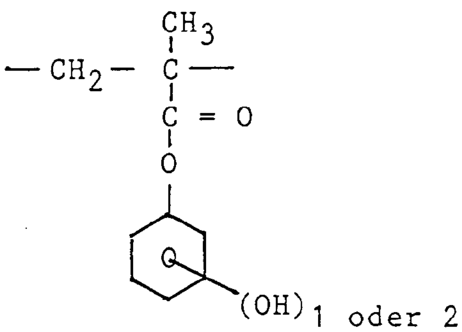

9. Strahlungempfindliches Aufzeichnungsmaterial mit einem Schichtträger und einer strahlungsempfindlichen Aufzeichnungsschicht, die als wesentlichen Bestandteil ein Gemisch nach Ansprüchen 1 bis 8 enthält.

## Claims

1. A positive-working radiation-sensitive mixture which contains as essential constituents
   a) a water-insoluble polymeric binder which is soluble in aqueous alkaline solutions and
   b) a 1,2-quinone diazide or a combination of
      1) a compound forming strong acid when exposed to actinic radiation and
      2) a compound containing at least one cleavable C-O-C bond,
   
   characterized in that said mixture contains, as binder, a thermally self-crosslinking polymer containing units of the general formula I

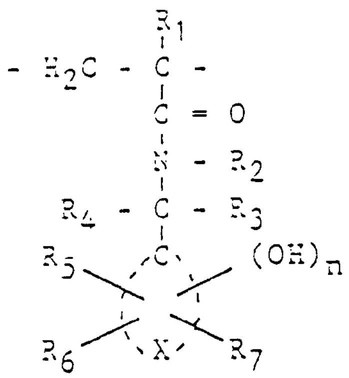

I

where

| | |
|---|---|
| $R_1$ | denotes a hydrogen or halogen atom, or a cyanide or an alkyl group, |
| $R_2$, $R_3$, $R_4$ | are identical or different and denote hydrogen, or alkyl or aryl groups, |
| $R_5$, $R_6$ and optionally $R_7$ | are identical or different and denote hydrogen or halogen atoms, or alkyl, aryl or alkoxy groups, and |
| X | denotes the atoms necessary to complete a mononuclear or polynuclear carbocyclic aromatic ring system, and |
| n | is 1, 2 or 3. |

**2.** A mixture as claimed in claim 1, wherein

| | |
|---|---|
| $R_1$ | denotes a hydrogen or halogen atom, or a cyanide or a $C_1$-$C_6$ alkyl group, |
| $R_2$, $R_3$, $R_4$ | are identical or different and denote hydrogen or $C_1$-$C_6$ alkyl groups, |
| $R_5$, $R_6$ and optionally $R_7$ | are identical or different and denote hydrogen or $C_1$-$C_4$ alkyl groups, and |
| X | denotes the carbon atoms necessary to complete a benzene or naphthalene ring, and |
| n | is 1. |

**3.** A mixture as claimed in claim 1 or 2, wherein

| | |
|---|---|
| $R_1$ | denotes hydrogen or a methyl group, |
| $R_2$, $R_3$, $R_4$ | denote hydrogen, |
| $R_5$ | denotes hydrogen, a $C_1$-$C_4$ alkyl group or a halogen atom, |
| $R_6$ | denotes hydrogen, a $C_1$-$C_4$ alkyl group, an aryl group or halogen, |
| $R_7$ | denotes hydrogen, and |
| X | denotes the carbon atoms necessary to complete a benzene or naphthalene ring, and |
| n | is 1. |

**4.** A mixture as claimed in claims 1 to 3, characterized in that it contains, as binder, a polymer containing units of the general formula II

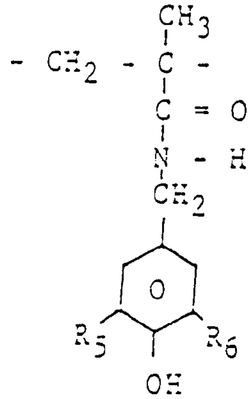

II

wherein
$R_5$ and $R_6$ are identical or different and denote hydrogen, $C_1$-$C_4$ alkyl or halogen.

**5.** A mixture as claimed in claims 1 to 3, characterized in that it contains, as binder, a polymer containing units of the general formula III

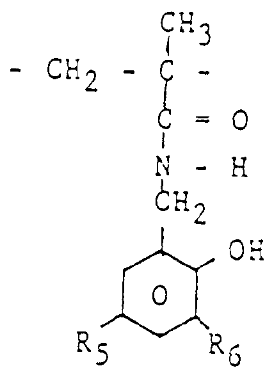

III

wherein
$R_5$ denotes $C_1$-$C_4$ alkyl or halogen and
$R_6$ denotes $C_1$-$C_4$ alkyl, halogen or an optionally substituted aryl.

**6.** A mixture as claimed in claim 1, wherein the polymeric binder furthermore contains one or more different repeating units of the general formula IV

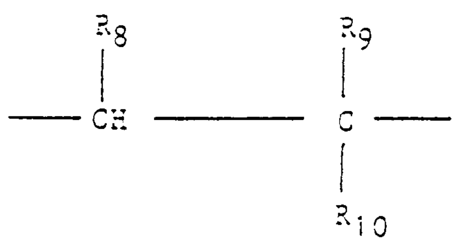

IV

wherein
$R_8$ denotes hydrogen or a carboxyl group which may be joined to $R_9$, if the latter is a carboxyl group, to form an acid anhydride or an optionally substituted imide,
$R_9$ denotes an alkyl, alkoxy, alkoxycarbonyl, acyl, acyloxy, aryl, aryloxycarbonyl, formyl, cyanide,-carboxyl, hydroxyl or amino carbonyl group, and
$R_{10}$ denotes hydrogen, halogen or an alkyl group.

**7.** The mixture as claimed in claim 6, wherein
$R_8$ denotes hydrogen,
$R_9$ denotes a $C_1$-$C_4$ alkyl group, a $C_1$-$C_8$ alkoxy group, an alkoxy carbonyl group containing 2-13 carbon atoms, an acyloxy group containing 2-18 carbon atoms, an aryl group containing 6-10 carbon atoms or an aryloxycarbonyl group containing 7-11 carbon atoms, where the aryl groups may be substituted by hydroxyl groups, and
$R_{10}$ denotes hydrogen or a methyl group.

**8.** A mixture as claimed in claim 6, wherein the formula IV stands for one of the following units:

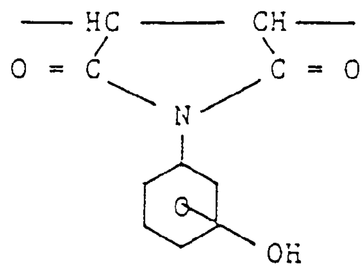

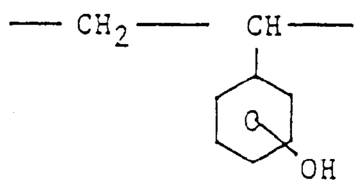

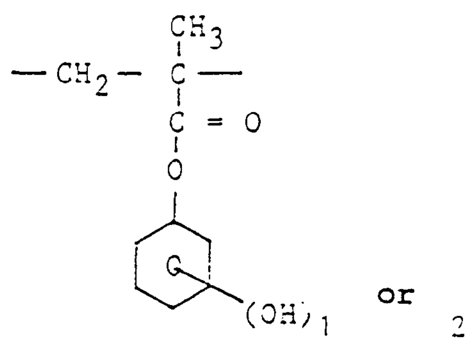

**9.** A radiation-sensitive copying material comprising a layer support and a radiation-sensitive copying layer which contains a mixture as claimed in claims 1 to 8 as essential constituent.

## Revendications

**1.** Composition sensible aux radiations, travaillant en positif, qui contient comme composants essentiels

a) un liant polymère insoluble dans l'eau, soluble dans des solutions aqueuses-alcalines, et

b) un 1,2-quinonediazide ou une association de

1) un composé formant un acide fort, sous l'effet d'un rayonnement actinique, et

2) un composé comportant au moins une liaison C-O-C clivable,

caractérisée en ce que la composition contient en tant que liant un polymère, susceptible d'autoréticulation thermique, à motifs de formule générale I

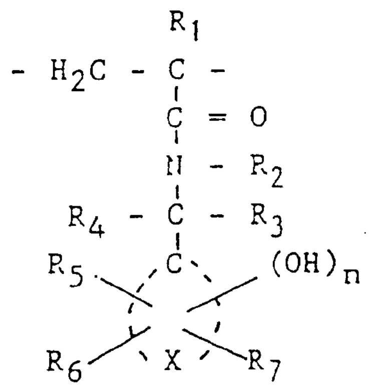

I

dans laquelle

R$_1$ est un atome d'hydrogène ou d'halogène, ou un groupe cyano ou alkyle,
R$_2$, R$_3$, R$_4$ sont identiques ou différents et représentent un atome d'hydrogène ou un groupe alkyle ou aryle,
R$_5$, R$_6$ et éventuellement R$_7$ sont identiques ou différents et représentent un atome d'hydrogène ou d'halogène ou un groupe alkyle, aryle ou alcoxy et
X représente les atomes requis pour compléter un système cyclique carbocyclique aromatique mono- ou polynucléaire, et
n est 1, 2 ou 3.

**2.** Composition selon la revendication 1, caractérisée en ce que
R$_1$ est un atome d'hydrogène ou d'halogène, ou un groupe cyano ou alkyle en $C_1$-$C_6$,
R$_2$, R$_3$, R$_4$ sont identiques ou différents et représentent un atome d'hydrogène ou un groupe alkyle en $C_1$-$C_6$,
R$_5$, R$_6$ et éventuellement R$_7$ sont identiques ou différents et représentent un atome d'hydrogène ou un groupe alkyle en $C_1$-$C_4$, et
X représente les atomes de carbone requis pour compléter un cycle benzénique ou naphtalénique et
n est 1.

**3.** Composition selon la revendication 1 ou 2, caractérisée en ce que
R$_1$ est un atome d'hydrogène ou le groupe méthyle,
R$_2$, R$_3$, R$_4$ représentent des atomes d'hydrogène,
R$_5$ représente un atome d'hydrogène ou d'halogène ou un groupe alkyle en $C_1$-$C_4$,
R$_6$ représente un atome d'hydrogène ou d'halogène ou un groupe alkyle en $C_1$-$C_4$ ou aryle,
R$_7$ représente un atome d'hydrogène, et
X représente les atomes de carbone requis pour compléter un cycle benzénique ou naphtalénique et
n est 1.

**4.** Composition selon les revendications 1 à 3, caractérisée en ce que la composition contient en tant que liant un polymère à motifs de formule générale II

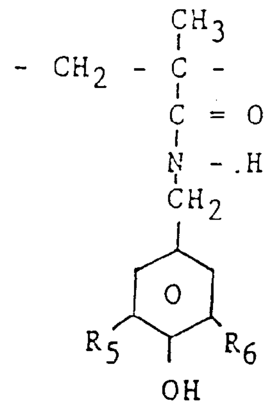

II

dans laquelle

$R_5$ et $R_6$ sont identiques ou différents et représentent un atome d'hydrogène ou d'halogène ou un groupe alkyle en $C_1$-$C_4$.

5. Composition selon les revendication 1 à 3, caractérisée en ce que la composition contient en tant que liant un polymère à motifs de formule générale III

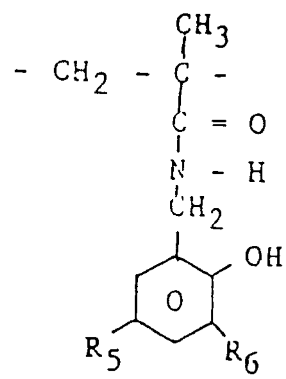

III

dans laquelle

$R_5$ représente un atome d'halogène ou un groupe alkyle en $C_1$-$C_4$, et

$R_6$ représente un groupe alkyle en $C_1$-$C_4$ ou un atome d'halogène, ou un groupe aryle éventuellement substitué.

6. Composition selon la revendication 1, caractérisée en ce que le liant polymère contient en outre un ou plusieurs motifs répétitifs différents de formule générale IV

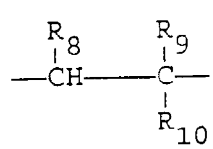

IV

dans laquelle

$R_8$ représente un atome d'hydrogène ou un groupe carboxy qui peut être lié à $R_9$ lorsque ce dernier est un groupe carboxy, pour donner un anhydride d'acide ou un imide éventuellement substitué,

$R_9$ représente un groupe alkyle, alcoxy, alcoxycarbonyle, acyle, acyloxy, aryle, aryloxycarbonyle, formyle, cyano, carboxy, hydroxy ou aminocarbonyle, et

$R_{10}$ représente un atome d'hydrogène ou d'halogène ou un groupe alkyle.

7. Composition selon la revendication 6, caractérisée en ce que

$R_8$ représente un atome d'hydrogène,

$R_9$ représente un groupe alkyle en $C_1$-$C_4$, un groupe alcoxy en $C_1$-$C_8$, un groupe alcoxycarbonyle ayant de 2 à 13 atomes de carbone, un groupe acyloxy ayant de 2 à 18 atomes de carbone, un groupe aryle ayant de 6 à 10 atomes de carbone ou un groupe aryloxycarbonyle ayant de 7 à 11 atomes de carbone, les groupes alkyle pouvant être substitués par des groupes hydroxy,

$R_{10}$ représente un atome d'hydrogène ou le groupe méthyle.

**8.** Composition selon la revendication 6, caractérisée en ce que la formule IV représente l'un des groupes suivants:

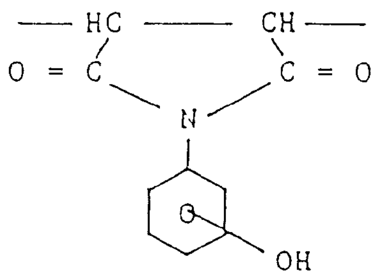

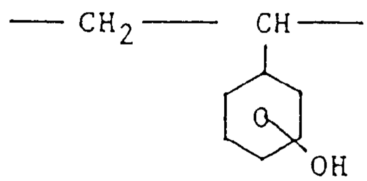

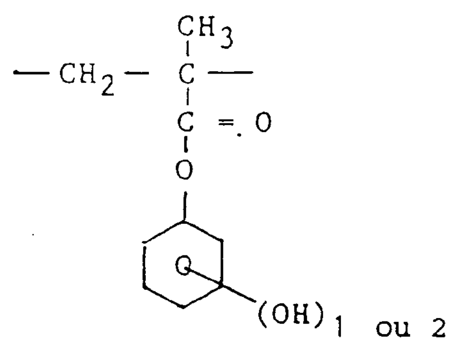

**9.** Matériau de reproduction sensible aux radiations, comportant un support de couche et une couche de reprographie sensible aux radiations, qui contient, en tant que composant essentiel, une composition selon les revendications 1 à 8.